# EUROPÄISCHE PATENTANMELDUNG

(11) **EP 0 973 366 A2**
(43) Veröffentlichungstag der Anmeldung: **19.01.2000**
(21) Anmeldenummer: 99810603.3
(22) Anmeldetag: 07.07.1999
(51) Int. Cl.: H05K 5/06, H05K 9/00

(54) **Blechgehäuse mit Dichtung**

(30) Priorität: 16.07.1998 DE 19831996
(71) Anmelder: Asea Brown Boveri AG, 5401 Baden (CH)
(72) Erfinder: Kammerl, Kurt, 79771 Klettgau (DE); Kölbl, Gustav, 8908 Hedingen (CH); Munoz, Enrique, 4132 Muttenz (CH); Vestner, Markus, 8238 Büsingen (CH)
(74) Vertreter: Kaiser, Helmut, Dr.

(57) **Zusammenfassung**

Das Blechgehäuse besteht aus mindestens zwei Blechteilen (1, 2) mit einer dazwischen angeordneten Dichtung (9) aus Kunststoff. Ein erster (1) der Teile ist entlang der Dichtung (9) zu einem Falz (10) umgefalzt und kontaktiert den zweiten Teil (2), derart, dass sich neben dem Falz (10) ein Spalt (13) zur Aufnahme der Dichtung (9) bildet. Der Falz (10) stellt einen guten elektrischen Kontakt zwischen den beiden Teilen (1, 2) und somit eine gute Abschirmung sicher. Gleichzeitig definiert er die Breite des Spalts (13), so dass die Dichtung (9) einer definierten Kompression ausgesetzt wird.

## Beschreibung

### Technisches Gebiet

Die Erfindung bezieht sich auf ein Blechgehäuse mit einer Dichtung aus Kunststoff gemäss Oberbegriff von Anspruch 1. Derartige Gehäuse werden insbesondere für elektrische Geräte verwendet, bei denen eine Abdichtung und elektromagnetische Abschirmung nach aussen wichtig ist.

### Stand der Technik

In bekannten Ausführungen von Gehäusen dieser Art wird die Dichtung zwischen den Blechen der Gehäuseteile eingeklemmt. Sodann werden die Gehäuseteile gegeneinander gedrückt, so dass die Dichtung komprimiert wird. Eine zu starke Kompression sollte jedoch vermieden werden, um Schäden an der Dichtung zu vermeiden. Eine zu schwache Kompression oder ein sich Setzen der Dichtung führt jedoch zu einer unerwünschten Lockerung der Verbindung. Für eine elektromagnetische Abschirmung müssen zusätzlich den Dichtungsspalt überdeckende Kontaktleisten angebracht werden.

Es stellt sich deshalb die Aufgabe, ein Blechgehäuse der eingangs genannten Art derart auszugestalten, dass diese Probleme in möglichst einfacher Weise vermieden werden.

### Darstellung der Erfindung

Die der Erfindung zugrunde liegende Aufgabe wird durch ein Blechgehäuse gemäss Anspruch 1 erfüllt. Der eine der Gehäuseteile bildet also eine Stufe entlang der Dichtung und kontaktiert den anderen Gehäuseteil. Die Anordnung ist so gewählt, dass sich neben der Stufe zwischen den Gehäuseteilen ein Spalt zur Aufnahme der Dichtung bildet. In dieser Konstruktion erfüllt die Stufe also zwei Funktionen: Einerseits stellt sie eine Erhöhung zur Bildung des elektrischen Kontakts zwischen den Gehäuseteilen sicher, so dass eine gute elektromagnetische Abschirmung gewährleistet ist. Andererseits bildet sie den mechanischen Kontakt und somit den Auflagebereich zwischen den Gehäuseteilen. Werden die Gehäuseteile gegeneinander gedrückt, so nimmt sie die entsprechenden Kräfte auf und eine übermässige Kompression der Dichtung wird vermieden.

Die erfindungsgemässe Ausgestaltung des Dichtungsbereichs kann durch blosses Biegen bzw. Falten der Gehäuseteile erreicht werden, was die Herstellung vereinfacht. Vorzugsweise wird dabei das Blech zu einem Falz umgebogen, der die Stufe bildet und gleichzeitig den Randbereich des Blechs verstärkt.

Vorzugsweise werden die beiden Gehäuseteile im Dichtungsbereich nach innen abgebogen und bilden Dichtungsflächen, zwischen welche die Dichtung zu liegen kommt. Der Innenrand des, vorzugsweise unteren, Gehäuseteils kann ausserdem derart umgebogen werden, dass er den Falz nach innen abdeckt. Dadurch wird eine bessere Abschirmung und ggf. Wasserabdichtung erreicht.

Zur besseren Verhinderung eines Wassereintritts können die Dichtungsflächen auch so angeordnet werden, dass sie nach innen gegen oben ansteigen.

Um die beiden Gehäuseteile gegeneinander zu drücken sind vorzugsweise geeignete Zugmittel vorgesehen.

### Kurze Beschreibung der Zeichnungen

Weitere Vorteile und Anwendungen der Erfindung ergeben sich aus den abhängigen Ansprüchen und aus der nun folgenden Beschreibung anhand der Figuren. Dabei zeigen:
Fig. 1 eine erste erfindungsgemässe Ausführung des Dichtungsbereichs eines Blechgehäuses,
Fig. 2 eine zweite erfindungsgemässe Ausführung des Dichtungsbereichs,
Fig. 3 eine dritte erfindungsgemässe Ausführung des Dichtungsbereichs mit innenliegender Dichtung und
Fig. 4 eine vierte erfindungsgemässe Ausführung des Dichtungsbereichs.

### Wege zur Ausführung der Erfindung

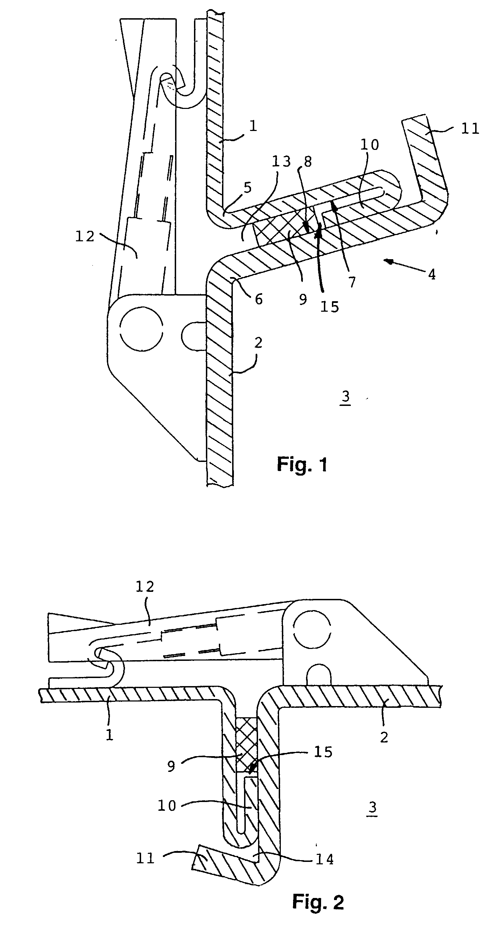

Figur 1 zeigt einen vertikalen Schnitt durch eine erste Ausführung eines erfindungsgemässen Blechgehäuses. Dabei wird nur der Bereich der Dichtung dargestellt. Die Ausgestaltung des übrigen Gehäuses kann in bekannter Weise den jeweiligen mechanischen und elektrischen Anforderungen angepasst sein. Das Gehäuse besteht zumindest teilweise aus Blech. Als Blechgehäuse sollen jedoch auch Gehäuse bezeichnet werden, die nicht nur aus Blechen bestehen.

Im vorliegenden Fall besteht das Blechgehäuse aus zwei Blechteilen 1, 2, die je aus einem geeignet gebogenen Blech gefertigt sind. Die Teile 1, 2 schirmen das Innere 3 des Gehäuses gegen aussen ab.

Im Dichtungsbereich 4 sind die beiden Blechteile 1, 2 entlang Kanten 5, 6 nach innen abgebogen und bilden zwei parallele Dichtungsflächen 7, 8, zwischen denen eine Dichtung 9 aus Kunststoff angeordnet ist.

Der obere, erste Gehäuseteil 1 ist an seinem inneren Rand um 180° umgefalzt und bildet einen Falz 10, der gegen aussen von der Dichtung 9 abgedichtet ist. Der untere, zweite Gehäuseteil 2 ist an seinem Inneren Rand um 90° nach oben umgebogen und bildet eine Zunge 11.

An der Aussenseite des Gehäuses ist zwischen den beiden Gehäuseteilen 1, 2 eine Zugvorrichtung 12 angeordnet, welche die Gehäuseteile 1, 2 gegeneinander zieht.

Durch den Zug der Zugvorrichtung 12 wird der Falz 10 gegen die Dichtungsfläche 8 des zweiten Gehäuseteils 2 gedrückt und bildet eine sichere elektrische Verbindung zwischen den beiden Teilen. Dadurch wird eine gute Abschirmungswirkung gegen elektromagnetische Immissionen und Emissionen erzielt. Gleichzeitig formt der Falz 10 auch den mechanischen Kontakt zwischen den Gehäuseteilen 1, 2. Er bildet eine Stufe 15, die sich der Dichtung entlang erstreckt und wirkt als Abstandshalter zur Bildung eines Spalts 13 zwischen den Dichtungsflächen 8, 9. Die Dichtung 9 ist so dimensioniert, dass sie entlang der Stufe 15 in diesem Spalt 13 unter leichter Kompression Platz findet. Somit ist, unabhängig von der Zugkraft der Zugvorrichtung 12 und dem Gewicht des oberen Gehäuseteils eine definierte Kompression der Dichtung 9 sichergestellt.

Wie aus Fig. 1 ersichtlich, steigen die beiden Dichtungsflächen 7, 8 gegen das Innere 4 des Gehäuses nach oben hin an. Damit wird verhindert, dass Wasser bei einem allfälligen Versagen der Dichtung 9 nach innen fliessen kann.

Fig. 2 zeigt eine zweite Ausführung des Dichtungsbereichs. In diesem Fall verläuft die Dichtung 9 horizontal. Der Aufbau des Dichtungsbereichs entspricht im wesentlichen jenem nach Fig. 1. Die Zunge 11 ist hier jedoch etwas weiter abgebogen, so dass sie eine Rinne 14 zum Auffangen von allfällig eintretendem Wasser bildet. Der Falz 10 bildet wiederum eine mechanische Stufe, die sich der Dichtung 9 entlang erstreckt.

Die beiden Figuren zeigen lediglich zwei der möglichen Ausführungen des Dichtungsbereichs. So ist es z.B. auch denkbar, den Falz 10 bzw. die Stufe 15 am unteren Gehäuseteil 2 auszubilden oder an beiden Gehäuseteilen je einen Falz vorzusehen. In diesen Fällen bildet der Falz jeweils selbst eine Rinne zur Aufnahme von Leckwasser.

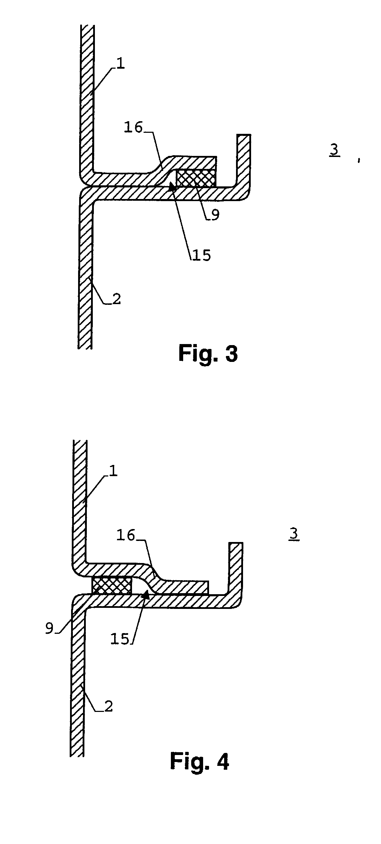

Fig. 3 zeigt eine weitere Ausführung der Erfindung, bei der die Stufe 15 nicht von einem Falz sondern von einer stufenförmigen Biegestelle 16 im Blech des ersten Gehäuseteils 1 gebildet wird. In dieser Ausführung liegt die Dichtung 9 innerhalb des Kontaktbereichs der beiden Gehäuseteile.

Fig. 4 zeigt schliesslich eine Ausführung ähnlich zu jener nach Fig. 3, wobei jedoch die Dichtung 9 ausserhalb des Kontaktbereichs der beiden Gehäuseteile liegt. Auch hier ist das Blech des ersten Gehäuseteils stufenförmig gebogen um die Stufe 15 zu bilden, die den Platz zur Aufnahme der Dichtung 9 schafft.

Zur Vereinfachung der Darstellung wird die Zugvorrichtung 12 in den Figuren 3 und 4 nicht gezeigt.

In allen diesen Ausführungen wird eine wetterfeste und elektrisch gut abschirmende Dichtung zwischen den beiden Gehäuseteilen erreicht, wobei jedoch die Herstellung des Gehäuses einfach bleibt.

### Bezugszeichenliste:

- 1:: erster Gehäuseteil
- 2:: zweiter Gehäuseteil
- 3:: Inneres des Gehäuses
- 4:: Dichtungsbereich
- 5:: erste Umfaltkante
- 6:: zweite Umfaltkante
- 7:: erste Dichtungsfläche
- 8:: zweite Dichtungsfläche
- 9:: Dichtung
- 10:: Falz
- 11:: Zunge
- 12:: Zugvorrichtung
- 13:: Spalt
- 14:: Rinne
- 15:: Stufe
- 16:: Biegestelle

## Patentansprüche

1. Blechgehäuse aus mindestens zwei Blechteilen (1,2) und mit einer zwischen den Blechteilen angeordneten Dichtung (9) aus Kunststoff, dadurch gekennzeichnet, dass ein erster (1) der Blechteile entlang der Dichtung (9) zur Bildung einer Stufe (16) gebogen ist und den zweiten (2) der Teile kontaktiert, derart, dass sich neben der Stufe (16) zwischen dem ersten und zweiten Blechteil ein Spalt (13) zur Aufnahme der Dichtung (9) bildet.

2. Blechgehäuse nach Anspruch 1, dadurch gekennzeichnet, dass der erste (1) und der zweite (2) Blechteil des Gehäuses in einem Dichtungsbereich (4) nach innen in das Blechgehäuse abgebogen sind, so dass sie im Dichtungsbereich (4) Dichtungsflächen (7, 8) zur Aufnahme der Dichtung (9) bilden, wobei die Dichtung (9) zwischen den Dichtungsflächen liegt.

3. Blechgehäuse nach Anspruch 2, dadurch gekennzeichnet, dass der Rand (11) des zweiten Blechteils im Dichtungsbereich (4) umgebogen ist und den Dichtungsbereich (4) gegen das Gehäuseinnere (3) abdeckt.

4. Blechgehäuse nach einem der Ansprüche 2 oder 3, dadurch gekennzeichnet, dass das Gehäuse eine Ober- und eine Unterseite aufweist, wobei zur Verhinderung eines Wassereintritts die Dichtungsflächen (7, 8) nach innen gegen die Oberseite hin ansteigend angeordnet sind.

5. Blechgehäuse nach den Ansprüchen 3 und 4, dadurch gekennzeichnet, dass im Dichtungsbereich (4) der erste Blechteil (1) gegen die Oberseite und der zweite Blechteil (2) gegen die Unterseite des Gehäuses angeordnet ist und der Rand (11) des zweiten Blechteils (2) zur Oberseite hin abgebogen ist.

6. Blechgehäuse nach einem der vorangehenden Ansprüche, gekennzeichnet durch Zugmittel (12) zum Zusammenziehen des ersten (1) und des zweiten (2) Blechteils.

7. Blechgehäuse nach einem der vorangehenden Ansprüche, dadurch gekennzeichnet, dass die Dichtung (9) die Stufe (16) gegen aussen abdichtet.

8. Blechgehäuse nach einem der vorangehenden Ansprüche, dadurch gekennzeichnet, dass der erste Blechteil entlang der Dichtung (9) zu einem Falz (10) umgebogen ist, wobei der Falz (10) die Stufe (16) bildet.
